# EUROPEAN PATENT APPLICATION

(11) **EP 1 585 215 A1**
(43) Date of publication of application: **12.10.2005**
(21) Application number: 05102746.4
(22) Date of filing: 07.04.2005
(51) Int. Cl.: H03F 1/30, H03F 3/72

(54) **Bias circuit for power amplifier operated as a digital to analog converter**

(30) Priority: 08.04.2004 US 820315
(71) Applicant: M/A-Com Eurotec B.V., Cork (IE)
(72) Inventor: Grebennikow, Andrei Viktorovich, Cork (IE); Heaney, Eugene Patrick, Cork (IE)
(74) Representative: Johnstone, Douglas Ian

(57) **Abstract**

An apparatus and method for biasing a power amplifier circuit operating as a Digital to Analog Converter (DAC) are described. The bias circuit comprises a first transistor with a reference voltage coupled to its base terminal, a second transistor coupled to the emitter terminal of the first transistor at its collector terminal, and a third transistor with its base terminal coupled to the first and second transistors, and to an input signal.

## Description

This present invention relates to bias circuits, and in particular, to a bias circuit for a power amplifier circuit operating as a Digital to Analog Converter (DAC).

In modem cellular telecommunication systems, like Wideband Code Division Multiple Access (WCDMA) or Single Carrier Radio Transmission Technology (1xRTT, also known as "CDMA2000"), it is necessary to feed a signal with a non-constant envelope through a power amplifier, or series of power amplifiers. In such cases, there is a tradeoff between power amplifier efficiency and linearity, with improvement in one coming at the expense of the other. Such cellular systems require such a power amplifier to deliver a wide range of output powers with 80 decibel (dB) dynamic range.

In a traditional envelope elimination restoration (EER) system, one type of power amplifier is responsible for envelope signal amplification (e.g., PA1), and another type of power amplifier receives a constant-envelope signal (e.g., PA2). While this approach is suitable for sufficiently low frequency operation with a narrow-band information signal, its efficiency degrades significantly due to increasing power consumption of the envelope signal power amplifier (e.g., PA1).

In a modem digital telecommunication signal, the complete radio frequency (RF) signal with amplitude and phase modulation can be easily split into separate 'envelope' and 'phase modulated' constant envelope signals, where the 'envelope' signal may be digitized using an Analog to Digital Converter (ADC). The 'envelope' signal must then be recovered at a receiver through the use of a Digital to Analog Converter (DAC), as discussed below.

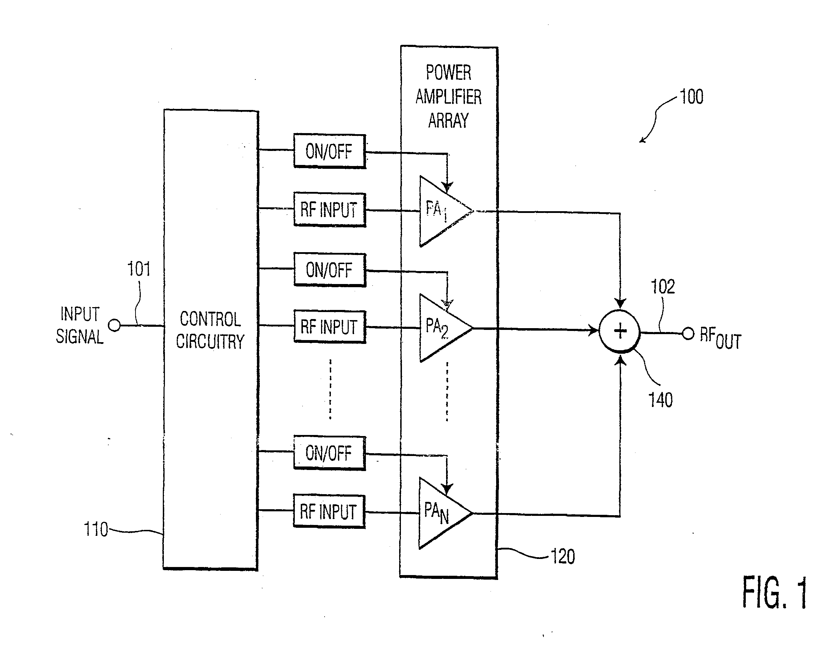

Figure 1 shows a conventional power amplifier circuit 100, which operates as a purely digital device wherein each power amplifier (e.g., PA₁ - PA_{N}) of a power amplifier array 120 is turned ON or OFF (by control circuitry 110) as required by the specific application. Such a power amplifier circuit is often referred to as an envelope Digital to Analog Converter (DAC), and is described in U.S. Pat. No. 6,255,906 to Eidson et al., which is incorporated herein by reference.

As shown in Figure 1, the power amplifier circuit 100 (operated as a DAC) includes an input terminal 101, and an output terminal 102. The control circuitry 110 coupled to the input terminal 101 is used to switch ON and OFF each of the plurality of power amplifiers PA₁ - PA_{N} depending upon the amount of gain required for the input signal. For example, if minimum gain is required, only PA₁ will be switched ON by the control circuitry 110. However, if maximum gain is required, PA₁ - PA_{N} will all be switched ON by the control circuitry 110. The output (gain portion) from each respective power amplifier PA₁ - PA_{N} of the array 120 are then combined by adder 140 to form an output signal which is presented at output terminal 102.

With regard to the power amplifier circuit 100, it is very difficult to realize the implementation of the power amplifier array 120 onto a monolithic integrated circuit (MMIC), as one needs to design N separate power amplifiers (e.g., PA₁ - PA_{N}), each with input, inter-stage and output matching circuits. Additionally, an N-port divider (e.g., control circuitry 110) is also required which significantly increases power consumption and cost of the telecommunications system.

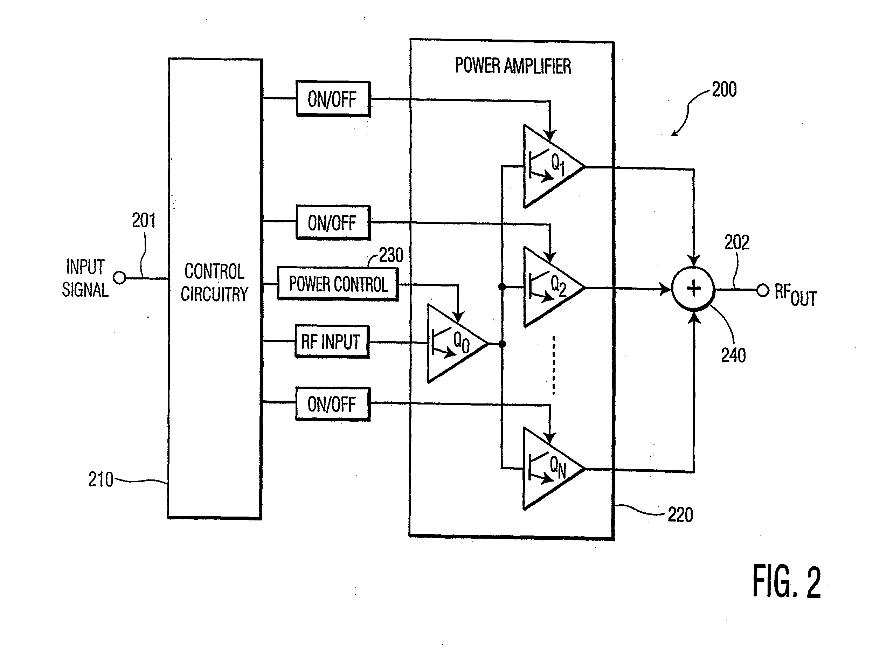

Figure 2 shows another conventional power amplifier circuit (operated as a DAC) 200 which solves the above-referenced implementation problem by using only one two-stage power amplifier array 220, where individual cells (e.g., Q₁ - Q_{N}) of the array operate like ON/OFF switches in accordance with current envelope signal amplitude. A first power device (cell) *Q*₀ is governed by a power control circuit 230 to provide a wide dynamic range of output powers flowing to the antenna (not shown, but coupled to the RFₒᵤₜ port). This wide dynamic range is provided by changing the base (or gate) bias voltage of the first power device (cell) *Q*₀, whereas the required envelope signal is restored by the switching of the base (or gate) bias voltage of each cell (e.g., Q₁ - Q_{N}) of the power amplifier array 220. The control circuitry 210 contains the analog-to-digital converter (ADC) and special logic circuitry for the appropriate ON/OFF switching of the power device cells Q₁ - Q_{N}.

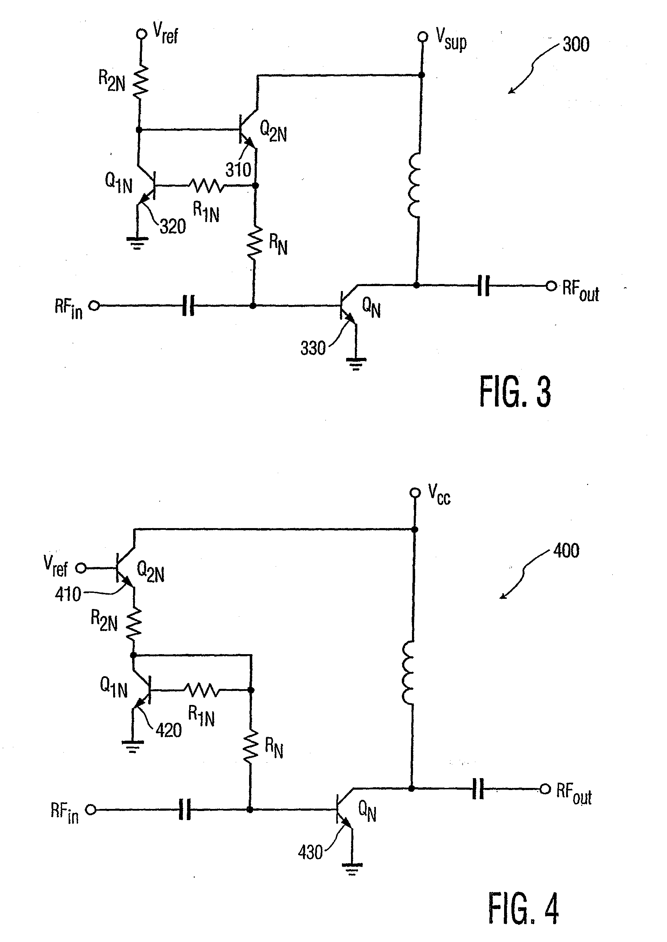

The proper ON/OFF switching of each power device cell Q₁ - Q_{N} of the power amplifier array 220 is provided by a specialized bias circuit (See Fig. 3). Each power device cell Q₁ - Q_{N} comprises a bipolar transistor and can be considered a voltage-controlled current source. The main function of the specialized bias circuit is to supply the base-emitter junction of each of the bipolar transistors (e.g., Q₁ - Q_{N}) with proper direct current (DC) when the device is ON, to provide significant isolation of the DC reference source from the RF path, and to minimize the amount of DC current from the reference source to minimize overall current consumption and maximize transmitter efficiency.

A conventional "current mirror" bias circuit 300 for biasing each of the device cells Q₁ - Q_{N} of the power amplifier circuit 200 is shown in Figure 3. The bias circuit 300 includes a first transistor 310 (Q_{2N}) with its base coupled to a reference voltage V_{ref,} a second transistor 320 (Q_{1N}) with its collector terminal also coupled to V_{ref,} and a third transistor 330 (Q_{N}) with its base coupled to an input radio frequency signal. In this schematic, the third transistor 330 (Q_{N}) represents each device cell (e.g., Q₁ - Q_{N}) of the power amplifier circuit (e.g., circuit 200) which must be turned ON and OFF.

This bias circuit 300 keeps the quiescent current for the devices Q₁ - Q_{N} sufficiently constant over temperature variations. The ratio between ballasting resistors *R*_{1N} and *R*_{N} is preferably equal to the ratio of device areas *Q*_{N}/*Q*_{1N} to minimize the overall performance variation with temperature, as well as to stabilize the DC bias point. Moreover, the current flowing through resistor *R*_{2N} should be equivalent to the collector current of the transistor *Q*_{1N}, and normally its value is on the order of several milliamperes (mA). For a large number of transistor cells (Q₁ - Q_{N}), the overall DC current from the reference voltage supply V_{ref} may have a significant value, thus reducing the transmitter efficiency.

The bias circuit 300 presents problems because a relatively large DC reference current (e.g., 2-5 mA) is required to switch ON each of the device cells Q₁ - Q_{N}. Additionally, the large quiescent current (*I*_{cq}) flowing in each of the device cells Q₁ - Q_{N}, created by the high DC reference current, results in higher DC current consumption, and lower efficiency of operation.

Thus, there is presently a need for a bias circuit for a power amplifier circuit which operates on a lower DC reference current with linearity.

An exemplary embodiment of the present invention comprises a bias circuit including a first transistor with a reference voltage coupled to its base terminal, a second transistor coupled to the emitter terminal of the first transistor at its collector terminal, and a third transistor with its base terminal coupled to the first and second transistors, and to an input signal.

An exemplary embodiment of the present invention also comprises a method for biasing a power amplifier, including, coupling a reference terminal to a base terminal of a first transistor, coupling an emitter terminal of the first transistor to at least one device cell of the power amplifier and to a collector terminal of a second transistor, and applying a DC reference current at the reference terminal in order to bias the at least one device cell.

An exemplary embodiment of the present invention also comprises a power amplifier circuit including at least one control circuit coupled to an input terminal, a power amplifier array coupled to the at least one control circuit, and an adder coupled to at least one output of the power amplifier array and coupled to an output terminal, wherein the power amplifier array further comprises at least one bias circuit, said bias circuit including a first transistor with a reference voltage coupled to its base terminal, a second transistor coupled to the emitter terminal of the first transistor at its collector terminal, and a third transistor with its base terminal coupled to the first and second transistors, and to an input signal.

The invention will now be described by way of example only with reference to the accompanying drawings in which:

Figure 1 shows a schematic diagram of a conventional power amplifier array.

Figure 2 shows a schematic diagram of another conventional power amplifier array.

Figure 3 shows a schematic diagram of a conventional current mirror bias circuit.

Figure 4 shows a schematic diagram of a bias circuit according to an exemplary embodiment of the present invention

Figure 5 shows a graph of reference voltage versus quiescent current for the bias circuits of Figures 3 and 4.

The present invention comprises, in one exemplary embodiment, a bias circuit 400 as shown in Figure 4. The bias circuit 400 is preferably used to bias the device cells (e.g., Q₁ - Q_{N}) of a power amplifier circuit (e.g., power amplifier circuit (DAC) 200 shown in Figure 2).

The bias circuit 400 includes a first transistor 410 (Q_{2N}) with its base coupled to a reference voltage V_{ref,} a second transistor 420 (Q_{1N}) coupled to the emitter of the first transistor, and a third transistor 430 (Q_{N}) with its base coupled to an input radio frequency signal. In this schematic, the third transistor 430 (Q_{N}) represents each device cell (e.g., Q₁ - Q_{N}) of the power amplifier circuit which must be turned ON and OFF. Because the reference voltage V_{ref} is coupled directly to the base of the first transistor 410 (Q_{2N}), the DC current required for the bias circuit 400 to switch ON the third transistor 430 (Q_{N}) is very small. For example, the bias circuit 400 requires only several tens of microamperes (µA) of reference current (from reference voltage V_{ref}), whereas the bias circuit 300 (See Figure 3) requires a few of milliamperes (mA) of reference current. Obviously, a difference of a factor of a thousand (1000) in terms of reference current is substantial.

In addition, although both bias circuits 300, 400 have essentially the same current-voltage response behavior for the same circuit parameters (e.g., the same values of *R*_{N}, *R*_{1N} and *R*_{2N} and the same devices areas for *Q*_{N,} *Q*_{1N} and *Q*_{2N}), the bias circuit 400 is less sensitive to reference voltage (V_{ref}) variations as compared to the bias circuit 300. This factor becomes important to efficiency because increasing the quiescent current results in higher DC current consumption, and lower efficiency of operation.

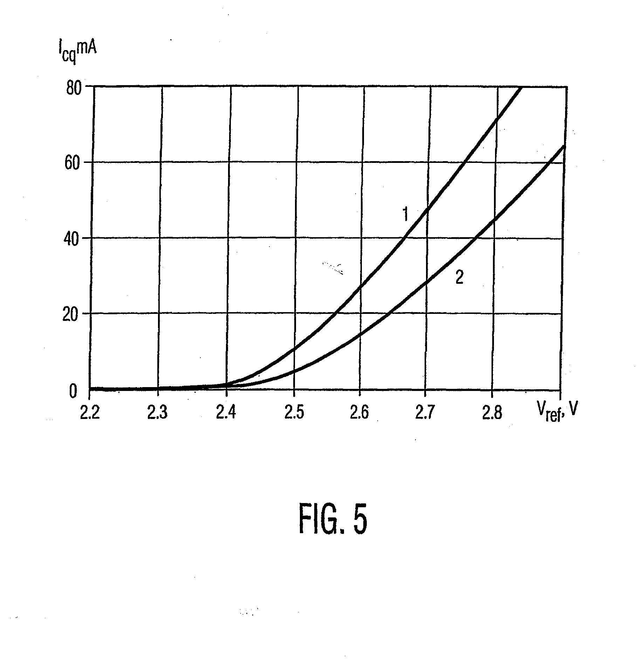

Figure 5 is a graph showing the reference voltage (V_{ref}) sensitivities of the quiescent current (*I*_{cq}) for both bias circuits 300, 400. Both bias circuits 300, 400 have the same current-voltage behavior but, for the same circuit parameters (*R*₀, *R*₁ and *R*₂) and devices areas for *Q*₀, *Q*₁ and *Q*₂, bias circuit 400 according to the present invention (Curve 2) is less sensitive to the reference voltage variations as compared with the conventional bias circuit 300 (Curve 1). Variations of the collector supply voltage (*V*ₛᵤₚ) between the limits of 3.0 V to 5.0 V (required for wireless handset transmitters) have no effect on quiescent current (*I*_{cq}) set by the reference voltage *V*_{ref.}

For the bias circuit 300, the DC current from reference voltage source *V*_{ref} is typically substantially higher than DC current flowing to the base of the first transistor 310 (*Q*_{2N}), due in part to the current drawn by the second transistor 320 (*Q*_{1N}) and the voltage drop variations across the resistor *R*_{2N}. In such a case, any variations of the base current to first transistor 310 (*Q*_{2N}) can cause subsequent variations in the DC bias voltage for the third transistor 330 (*Q*_{N}). These variations of DC bias voltage for the third transistor 330 (*Q*_{N}) can cause a problem with linearity of RF signal because a sufficient amount of quiescent current (*I*_{cq}) is required for linear operation of the power amplifier circuit (e.g., power amplifier circuit 200). When the DC current from reference voltage V_{ref} is high enough, the base current for the first transistor 310 (Q_{2N}) becomes only a very small part of this current, and thus any variations therein do not have a serious effect on DC biasing of the third transistor 330 (*Q*_{N}).

Accordingly, the reference voltage *V*_{ref} for the bias circuit 400 according to the present invention is made to provide a DC current directly to the base of the first transistor 410 (*Q*_{2N}), rather than through a resistor (e.g., *R*_{2N}), to avoid the above-referenced variations (and related linearity problems). The coupling of the second transistor 420 (*Q*_{1N}) to the emitter of the first transistor 410 (*Q*_{2N}) also reduces variations in the DC bias voltage applied to the third transistor 430 (*Q*_{N}), and thus increases linearity.

Although the invention has been described in terms of exemplary embodiments, it is not limited thereto. Rather, the appended claims should be construed broadly to include other variants and embodiments of the invention which may be made by those skilled in the art without departing from the scope and range of equivalents of the invention.

## Claims

1. A bias circuit comprising:
a first transistor with a reference voltage coupled to its base terminal;
a second transistor coupled to the emitter terminal of the first transistor at its collector terminal; and,
a third transistor with its base terminal coupled to the first and second transistors, and to an input signal.

2. The bias circuit of claim 1, further comprising a first resistor coupled in series between the emitter terminal of the first transistor and the collector terminal of the second transistor.

3. The bias circuit of claim 1, wherein the input signal comprises a radiofrequency signal.

4. The bias circuit of claim 1, wherein a second reference voltage applied to the base of the third transistor is substantially linear.

5. The bias circuit of claim 1, wherein the quiescent current of the bias circuit is substantially linear.

6. A method for biasing a power amplifier, comprising the steps of:
coupling a reference terminal to a base terminal of a first transistor;
coupling an emitter terminal of the first transistor to at least one device cell of the power amplifier and to a collector terminal of a second transistor; and,
applying a DC reference current at the reference terminal in order to bias the at least one device cell.

7. The method of claim 6, wherein the step of applying a DC reference current comprises applying a current in the range from 10 to 100 microamperes.

8. The method of claim 6, wherein a reference voltage applied to the at least one device cell is substantially linear.

9. A power amplifier circuit comprising:
at least one control circuit coupled to an input terminal;
a power amplifier array coupled to the at least one control circuit; and,
an adder coupled to at least one output of the power amplifier array and coupled to an output terminal,
wherein the power amplifier array further comprises at least one bias circuit, said bias circuit including a first transistor with a reference voltage coupled to its base terminal, a second transistor coupled to the emitter terminal of the first transistor at its collector terminal, and a third transistor with its base terminal coupled to the first and second transistors, and to an input signal.

10. The power amplifier of claim 9, wherein a second reference voltage applied to the base of the third transistor is substantially linear.
